# EUROPEAN PATENT APPLICATION

(11) **EP 2 159 301 A1**
(43) Date of publication of application: **03.03.2010**
(21) Application number: 08752985.5
(22) Date of filing: 20.05.2008
(51) Int. Cl.: C23C 14/34, C23C 14/06, G02B 1/11

(54) **LOW-REFRACTIVE INDEX FILM, METHOD FOR FORMING THE LOW-REFRACTIVE INDEX FILM, AND ANTIREFLECTION FILM**

(30) Priority: 28.06.2007 JP 2007170584
(71) Applicant: Sony Corporation, Tokyo 108-0075 (JP)
(72) Inventor: TAKETOMO, Mikihiro, Tokyo 108-0075 (JP); KAWASHIMA, Toshitaka, Tokyo 108-0075 (JP); OSHIMA, Yoshihiro, Tokyo 108-0075 (JP)
(74) Representative: Müller - Hoffmann & Partner
(86) International application number: PCT/JP2008/059189
(87) International publication number: WO 2009/001634

(57) **Abstract**

Provided is a method of depositing a low-refractive-index film, by which a thin film having uniform composition distribution in the film and having a low refractive index can be formed, a low-refractive-index film deposited by the method of depositing a low-refractive-index film, and furthermore, an antireflection film including the low-refractive-index film. In a method of depositing a low-refractive-index film including depositing a low-refractive-index film composed of MgF₂-SiO₂ on a substrate 11 by a reactive sputtering method, sputtering deposition is conducted using targets 4A and 4B composed of a sintered body of MgF₂-SiO₂ by applying an alternating voltage with a frequency in the range of 20 to 90 kHz between the substrate 11 and the targets 4A and 4B in an atmosphere of a mixed gas of an inert gas and O₂.

## Description

### Technical Field

The present invention relates to a low-refractive-index film deposited by a reactive sputtering method, a method of depositing the same, and an antireflection film including the low-refractive-index film.

### Background Art

In general, in a display device such as a cathode ray tube (CRT) or a liquid crystal display, an antireflection film is provided on a surface on which an image is displayed. This antireflection film is provided in order to reduce reflection of external light to reproduce a preferred image or text information and formed by stacking thin-film materials having different refractive indices.

Such an antireflection film is constituted by stacking, for example, on a transparent film base composed of an organic material, a low-refractive-index layer composed of a low-refractive-index material such as silicon oxide, silicon nitride, or magnesium fluoride and a high-refractive-index layer composed of a high-refractive-index material such as tin oxide-containing indium oxide (ITO), titanium oxide, tantalum oxide, or zirconium oxide.

Here, as for the low-refractive-index material, Japanese Unexamined Patent Application Publication No. 4-223401 discloses a material composed of Mg, Si, O, and F and describes, as Examples, a method using a binary target of MgF₂ and Si and a method conducted by placing Si pellets on MgF₂. However, in this method, the composition of a thin film to be prepared varies in the plane, resulting in an increase in the variation in the refractive index. Consequently, to improve the in-plane composition distribution, it is necessary to use a target having a uniform composition. However, in the case where a MgF₂-Si target is prepared, Si and F react with each other at a stage of mixing a MgF₂ powder with a Si powder, thereby generating a toxic gas such as SiF₄, which is hazardous.

Furthermore, Japanese Unexamined Patent Application Publication No. 2004-315834 discloses a method of mixing MgF₂ in SiO₂ glass. However, TiO₂ or GeO₂ is incorporated in order to decrease the melting point of the glass. Accordingly, the cost of the preparation of the target increases, and this target is not preferable as a target for forming a low-refractive-index film.

In order to solve the above problems, a MgF₂-SiO₂ target should be prepared by mixing stable materials, such as MgF₂ and SiO₂, with each other. However, even when such a target is used, it is difficult to deposit a low-refractive-index film suitable for an antireflection film.

The present invention has been made in view of the above problems in the related art. It is an object of the present invention to provide a method of depositing a low-refractive-index film, by which a thin film having a uniform composition distribution in the film and having a low refractive index can be formed, and a low-refractive-index film deposited by the method of depositing a low-refractive-index film. Furthermore, it is an object of the present invention to provide an antireflection film including the low-refractive-index film.

### Disclosure of Invention

The present invention provided in order to solve the above problems is a method of depositing a low-refractive-index film including depositing a low-refractive-index film composed of MgF₂-SiO₂ on a substrate by a reactive sputtering method, **characterized in that** sputtering deposition is conducted using a target composed of a sintered body of MgF₂-SiO₂ by applying an alternating voltage with a frequency in the range of 20 to 90 kHz between the substrate and the target in an atmosphere of a mixed gas of Ar and O₂.

Here, the content of SiO₂ in the target is preferably in the range of 5 to 80 mole percent.

Furthermore, an O₂ flow rate ratio of the mixed gas is preferably in the range of 10% to 70%.

In addition, the present invention provided in order to solve the above problems is a low-refractive-index film characterized by being deposited by the method of depositing a low-refractive-index film described in any one of Claims 1 to 3.

In addition, the present invention provided in order to solve the above problems is an antireflection film **characterized in that** a high-refractive-index layer and a low-refractive-index layer composed of the low-refractive-index film described in Claim 4 are stacked on a substrate.

According to the method of depositing a low-refractive-index film of the present invention, a low-refractive-index film composed of a fluoride and having a uniform composition distribution can be deposited by a sputtering method. In addition, by appropriately adjusting the composition of MgF₂-SiO₂, a low-refractive-index film having any optical properties can be obtained.

According to the low-refractive-index film of the present invention, a low-refractive-index film having uniform optical properties in the film surface can be provided.

According to the low-refractive-index film of the present invention, an antireflection film having a uniform and good antireflection function in the film surface can be provided.

### Brief Description of Drawings

[Fig. 1] Fig. 1 is a schematic view showing the structure of a reactive sputtering apparatus used in the present invention.
[Fig. 2] Fig. 2 includes transmittance and reflectance curves of samples prepared in Example 1 under the conditions of an introduced mixed gas of Ar + O₂ and an AC discharge.
[Fig. 3] Fig. 3 includes transmittance and reflectance curves of samples prepared in Example 1 under the conditions of an introduced mixed gas of Ar + CF₄.
[Fig. 4] Fig. 4 is a cross-sectional view showing the structure of an antireflection film of Example 2.
[Fig. 5] Fig. 5 is a graph showing a spectral reflectance characteristic of the antireflection film of Example 2.

### Best Modes for Carrying Out the Invention

A method of depositing a low-refractive-index film according to the present invention will be described below. Note that the present invention will be described on the basis of embodiments shown in the drawings, but the present invention is not limited thereto and can be appropriately changed in accordance with an embodiment. Any embodiment is included within the scope of the present invention as long as operations and advantages of the present invention can be achieved.

The method of depositing a low-refractive-index film according to the present invention is a method of depositing a low-refractive-index film including depositing a low-refractive-index film composed of MgF₂-SiO₂ on a substrate by a reactive sputtering method, **characterized in that** sputtering deposition is conducted using a target composed of a sintered body of MgF₂-SiO₂ by applying an alternating voltage with a frequency in the range of 20 to 90 kHz between the substrate and the target in an atmosphere of a mixed gas of Ar and O₂.

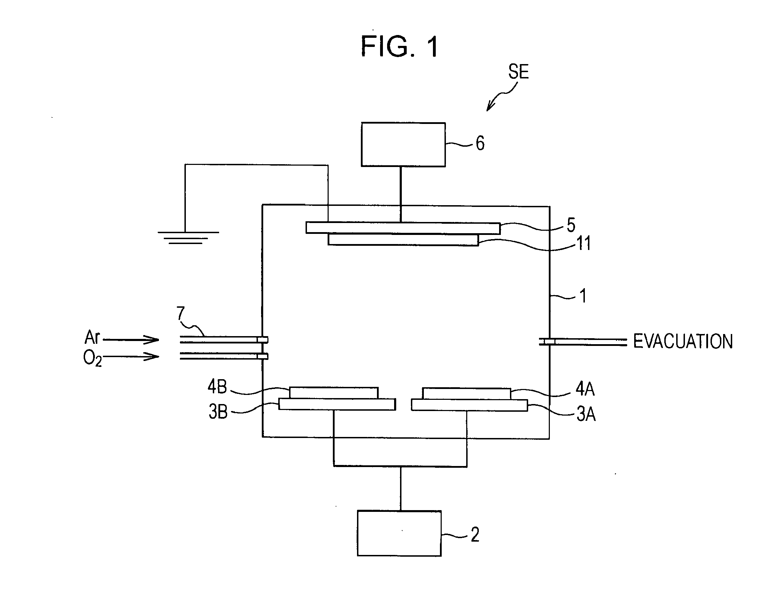

Here, Fig. 1 shows a structural example of a reactive sputtering apparatus to which the method of depositing a low-refractive-index film of the present invention is applied.

As shown in Fig. 1, a reactive sputtering apparatus SE includes a vacuum chamber 1, a substrate holder 5 that holds a substrate 11 on which a thin film is to be formed, the substrate holder 5 being disposed on an upper part of the inside of the vacuum chamber 1, and driving means 6 for rotating the substrate holder 5. Furthermore, a vacuum pump (not shown) for evacuating the inside of the vacuum chamber 1 is connected to the vacuum chamber 1, and thus the vacuum chamber 1 is configured so that the degree of vacuum in the inside of the vacuum chamber 1 can be adjusted to any value.

On the lower part of the inside of the vacuum chamber 1, sputtering electrodes (cathodes) 3A and 3B, which are connected to an AC power supply 2 serving as a sputtering power supply, and targets 4A and 4B having a flat-plate shape and disposed on the sputtering electrodes 3A and 3B, respectively, are disposed so as to face the substrate 11. Note that the targets 4A and 4B are obtained by mixing a MgF₂ powder with a SiO₂ powder, and then conducting sintering. In the present invention, the content of SiO₂ of the sintered body is preferably in the range of 5 to 80 mole percent.

In addition, two types of gas introduction pipes 7 for introducing gases into the chamber are connected to the vacuum chamber 1. One of the pipes is configured so that a sputtering gas, the flow rate of which is adjusted by a mass flow controller which is not shown in the figure, is introduced into the vacuum chamber 1. Here, the sputtering gas is an inert gas, and is preferably, for example, one or more types of gases selected from Ar, Xe, Ne, and Kr.

Furthermore, the other pipe is configured so that O₂ gas, the flow rate of which is adjusted by a mass flow controller which is not shown in the figure, is introduced as a reactive gas into the vacuum chamber 1.

Accordingly, the atmosphere in the vacuum chamber 1 becomes a mixed atmosphere of the inert gas and O₂ gas, and the targets 4A and 4B are sputtered by the sputtering gas.

Note that in the present invention, various known sputtering methods such as magnetron sputtering, diode sputtering in which magnetron discharge is not used, ECR sputtering, and bias sputtering can be used.

Here, a low-refractive-index film of the present invention is obtained by performing deposition by the following procedure using the reactive sputtering apparatus SE.
(S11) The substrate 11 is held on the substrate holder 5, and the targets 4A and 4B are disposed at predetermined positions of the sputtering electrodes 3A and 3B, respectively.
(S12) The inside of the vacuum chamber 1 is evacuated so that the pressured in the inside thereof is reduced to a predetermined pressure or less, and the substrate holder 5 is rotated.
(S13) The sputtering gas and O₂ gas are introduced into the vacuum chamber 1. In this step, the O₂ gas and the sputtering gas are introduced while adjusting the flow rates of the gases to a predetermined flow rate ratio, thus controlling to the predetermined pressure. The O₂ flow rate ratio is preferably, for example, in the range of 10% to 70%, and most preferably in the range of 20% to 50%.
(S14) Next, an electrical power is provided to the sputtering electrodes 3A and 3B. In this step, an alternating voltage is applied, and the frequency thereof is preferably in the range of 20 to 90 kHz, and in particular, most preferably 90 kHz. Consequently, plasma is generated on the targets 4A and 4B, and sputtering of the targets 4A and 4B is started.
(S15) When a sputtering state becomes stable, deposition on the substrate 11 attached to the substrate holder 5 is started. Thus, a low-refractive-index film composed of MgF₂-SiO₂ having a predetermined thickness is obtained.

A transparent thin film composed of MgF₂-SiO₂ and having a lower refractive index than that of a SiO₂ film can be readily formed by this deposition method.

### EXAMPLES

Examples performed for verifying the present invention will be described below.

### (EXAMPLE 1)

A description will be made of an example in which low-refractive-index films were deposited by the method of depositing a low-refractive-index film of the present invention using the reactive sputtering apparatus SE shown in Fig. 1. Note that, as for sputtering conditions, targets 4A and 4B: MgF₂-SiO₂ sintered body (MgF₂:SiO₂ = 70:30 atomic percent), sputtering gas: Ar, and reactive gas: O₂ were used as common conditions, and the Ar gas was introduced with a back pressure in the vacuum chamber 1 of 5 × 10⁻⁴ Pa or less, and pre-sputtering was performed. Subsequently, low-refractive-index films were prepared under the deposition conditions below. Note that (O₂ gas flow rate ratio) = (O₂ gas flow rate)/{(O₂ gas flow rate) + (Ar gas flow rate)} × 100 (%).

### (Deposition conditions)

· Substrate 11: transparent glass substrate
· O₂ gas flow rate ratio: 0%, 20%, 40%, 50%, and 100%
· Frequency of AC power supply: 90 kHz
· Supplied electrical power: 400 W
· Total pressure: 0.37 to 0.39 Pa

Furthermore, sputtering deposition was performed under the deposition conditions below using a radio-frequency power supply (RF power supply) instead of the AC power supply 2 in the reactive sputtering apparatus SE shown in Fig. 1.

### (Deposition conditions)

· Substrate 11: transparent glass substrate
· Targets 4A and 4B: MgF₂-SiO₂ sintered body (MgF₂:SiO₂ = 70:30 atomic percent)
· O₂ gas flow rate ratio: 0%, 20%, and 50%
· Frequency of RF power supply: 13.56 MHz
· Supplied electrical power: 300 W
· Total pressure: 0.39 Pa

The refractive indices and extinction coefficients at a wavelength of 550 nm, and the transmittances of the obtained samples were measured. The results are shown in Table 1. In the case of AC discharge (in the case where the AC power supply was used), the refractive index and extinction coefficient of the sample prepared at an O₂ flow rate ratio of O% could not be measured because of high absorption, but the refractive indices of other samples (prepared at an O₂ flow rate ratio of 20%, 40%, 50%, and 100%) were less than 1.5 (about 1.4). Furthermore, according to the results of an XPS analysis of the composition of the optical film of Sample No. 4 (Ar: 100 sccm, O₂: 100 sccm, O₂ flow rate ratio: 50%, total pressure: 0.38 Pa, and electrical power: 400 W), C was 3.89 atomic percent, O was 9.99 atomic percent, F was 55.53 atomic percent, Mg was 27.92 atomic percent, Si was 2.66 atomic percent, and the concentration ratio of F to Mg was 1.99. In addition, in the case of RF discharge (in the case where the radio-frequency power supply was used), the refractive indices were 1.5 or more, and thus it is believed that optical films composed of MgO and SiO₂ were formed.

**[Table 1]**

| No. | Discharge method | Introduced gas | | | Total pressure (Pa) | Electrical power (W) | Film thickness (nm) | Deposition rate (nm/min) | Evaluation results | | |
|---|---|---|---|---|---|---|---|---|---|---|---|
| | | Ar (sccm) | O₂ (sccm) | O₂ flow rate ratio | | | | | Refractive index (550 nm) | Extinction coefficient k (550 nm) | Transmittance^{*1} (%) |
| 1 | AC | 200 | 0 | 0% | 0.39 | 400 | 40 | 0.36 | Could not be measured. | Could not be measured. | 91.67 |
| 2 | AC | 160 | 40 | 20% | 0.39 | 400 | 80.9 | 0.34 | 1.406 | 0 | 94.09 |
| 3 | AC | 120 | 80 | 40% | 0.39 | 400 | 72.1 | 0.33 | 1.445 | 0 | 93.08 |
| 4 | AC | 100 | 100 | 50% | 0.38 | 400 | 89.6 | 0.37 | 1.390 | 0 | 94.28 |
| 5 | AC | 0 | 200 | 100% | 0.37 | 400 | 85.8 | 0.36 | 1.464 | 0 | 94.17 |
| 6 | RF | 200 | 0 | 0% | 0.39 | 300 | 178.3 | 1.49 | 1.544 | 0.003792 | 87.96 |
| 7 | RF | 160 | 40 | 20% | 0.39 | 300 | 163.4 | 1.36 | 1.563 | 0 | 92.24 |
| 8 | RF | 100 | 100 | 50% | 0.39 | 300 | 131.6 | 1.10 | Could not be measured. | Could not be measured. | 91.40 |

| | | | | | | | | | | | |
|---|---|---|---|---|---|---|---|---|---|---|---|
| *Average of the transmittances at wavelengths in the range of 500 to 600 nm. | | | | | | | | | | | |

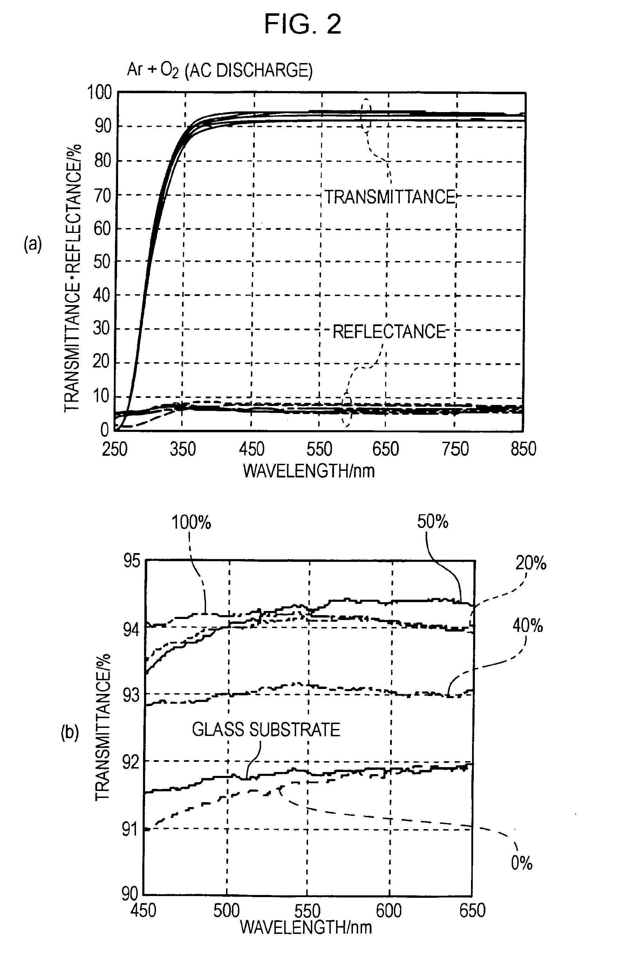

Fig. 2 shows transmittance and reflectance curves in the case of the AC discharge (in which the O₂ flow rate ratio was 0%, 20%, 40%, 50%, or 100%). All the samples showed substantially constant transmittance and reflectance in a wavelength range of 400 nm or more ((a) of Fig. 2). Furthermore, the samples prepared at an O₂ flow rate ratio of 20%, 40%, 50%, and 100% showed higher transmittances than that of a glass substrate ((b) of Fig. 2).

Next, thin-film samples were prepared under the conditions below using the reactive sputtering apparatus SE shown in Fig. 1.

### (1) Deposition conditions 1 (Sample Nos. 9 to 11)

· Substrate 11: transparent glass substrate
· Targets 4A and 4B: MgF₂-SiO₂ sintered body (MgF₂:SiO₂ = 70:30 atomic percent)
· Introduced mixed gas: Ar + CF₄
· Gas flow rate (Ar/CF₄): 160/40, 100/100, and 0/200 sccm (20%, 50%, and 100%, respectively, in terms of the CF₄ gas flow rate ratio)
· Frequency of AC power supply: 90 kHz
· Supplied electrical power: 400 W
· Total pressure: 0.4 to 0.43 Pa

### (2) Deposition conditions 2 (Sample Nos. 12 to 14)

· Substrate 11: transparent glass substrate
· Targets 4A and 4B: MgF₂-SiO₂ sintered body (MgF₂:SiO₂ = 70:30 atomic percent)
· Introduced mixed gas: Ar + O₂ + CF₄
· Gas flow rate (Ar/O₂/CF₄) : 100/10/90, 100/30/70, and 100/70/30 sccm
· Frequency of AC power supply: 90 kHz
· Supplied electrical power: 400 W
· Total pressure: 0.4 Pa

### (3) Deposition conditions 3 (Sample Nos. 15 to 17) ·Substrate 11: transparent glass substrate

· Targets 4A and 4B: MgF₂-SiO₂ sintered body (MgF₂:SiO₂ = 70:30 atomic percent)
· Introduced mixed gas: Ar + CO₂
· Gas flow rate (Ar/CO₂): 160/40, 100/100, and 0/200 sccm (20%, 50%, and 100%, respectively, in terms of the CO₂ gas flow rate ratio)
· Frequency of AC power supply: 90 kHz
· Supplied electrical power: 400 W
· Total pressure: 0.38 to 0.39 Pa

Furthermore, sputtering deposition was performed under the deposition conditions below using a radio-frequency power supply (RF power supply) instead of the AC power supply 2 in the reactive sputtering apparatus SE shown in Fig. 1.

### (4) Deposition conditions 4 (Sample Nos. 18 and 19) ·Substrate 11: transparent glass substrate

· Targets 4A and 4B: MgF₂-SiO₂ sintered body (MgF₂:SiO₂ = 70:30 atomic percent)
· Introduced mixed gas: Ar + CF₄
· Gas flow rate (Ar/CF₄): 100/100 and 0/200 sccm (50% and 100%, respectively, in terms of the CF₄ gas flow rate ratio)
· Frequency of RF power supply: 13.56 MHz
· Supplied electrical power: 300 W
· Total pressure: 0.42 to 0.45 Pa

The refractive indices and extinction coefficients at a wavelength of 550 nm, and the transmittances of the obtained samples were measured. The results are shown in Table 2.

**[Table 2]**

| No. | Discharge method | Introduced gas | | | | Total pressure (Pa) | Electrical power (W) | Film thickness (nm) | Deposition rate (nm/min) | Evaluation results | | |
|---|---|---|---|---|---|---|---|---|---|---|---|---|
| | | Ar (sccm) | O₂ (sccm) | CF₄ (sccm) | CO₂ (sccm) | | | | | Refractive index (550 nm) | Extinction coefficient k (550 nm) | Transmittance^{*1} (%) |
| 9 | AC | 160 | 0 | 40 | 0 | 0.4 | 400 | 79 | 0.44 | Could not be measured. | Could not be measured. | 89.44 |
| 10 | AC | 100 | 0 | 100 | 0 | 0.41 | 400 | 77 | 0.43 | Could not be measured. | Could not be measured. | 87.96 |
| 11 | AC | 0 | 0 | 200 | 0 | 0.43 | 400 | 88 | 0.49 | Could not be measured. | Could not be measured. | 88.27 |
| 12 | AC | 100 | 10 | 90 | 0 | 0.4 | 400 | 86.8 | 0.41 | Could not be measured. | Could not be measured. | 84.39 |
| 13 | AC | 100 | 30 | 70 | 0 | 0.4 | 400 | 64 | 0.30 | Could not be measured. | Could not be measured. | 84.93 |
| 14 | AC | 100 | 70 | 30 | 0 | 0.4 | 400 | 65.2 | 0.31 | Could not be measured. | Could not be measured. | 89.74 |
| 15 | AC | 160 | 0 | 0 | 40 | 0.39 | 400 | 74.4 | 0.31 | 1.598 | 0.004195 | 91.45 |
| 16 | AC | 100 | 0 | 0 | 100 | 0.38 | 400 | 91.1 | 0.38 | 1.607 | 0 | 90.30 |
| 17 | AC | 0 | 0 | 0 | 200 | 0.38 | 400 | 92.6 | 0.39 | 1.448 | 0 | 92.19 |
| 18 | RF | 100 | 0 | 100 | 0 | 0.42 | 300 | 221 | 1.84 | Could not be measured. | Could not be measured. | 69.49 |
| 19 | RF | 0 | 0 | 200 | 0 | 0.45 | 300 | 241.8 | 2.02 | Could not be measured. | Could not be measured. | 80.55 |

| | | | | | | | | | | | | |
|---|---|---|---|---|---|---|---|---|---|---|---|---|
| *Average of the transmittances at wavelengths in the range of 500 to 600 nm. | | | | | | | | | | | | |

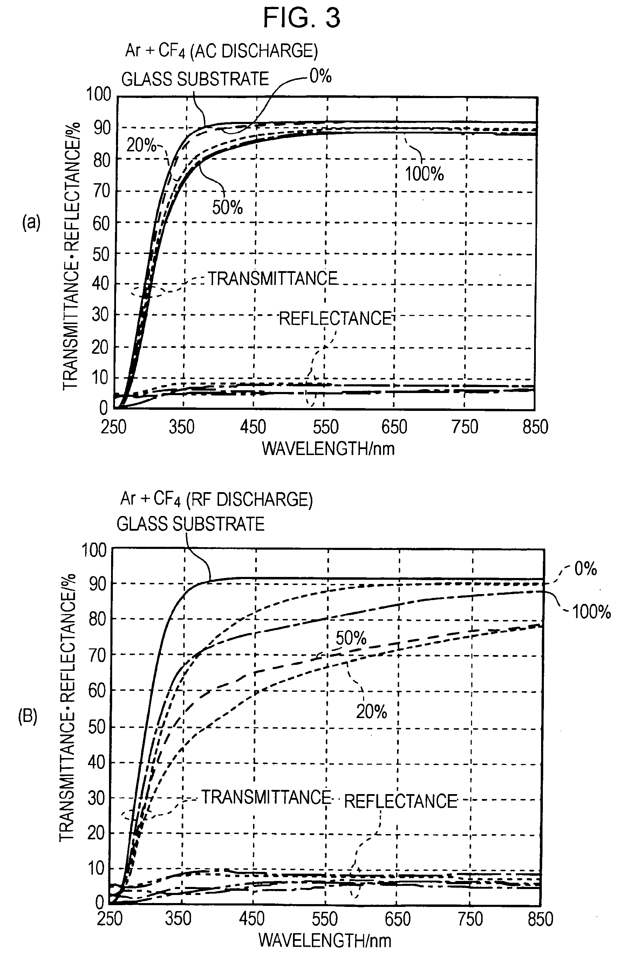

In all the samples obtained in the case where CF₄ gas was introduced, namely, Sample Nos. 9 to 11 (introduced mixed gas: Ar + CF₄, AC-discharge samples), Sample Nos. 12 to 14 (introduced mixed gas: Ar + O₂ + CF₄, AC-discharge samples), and Sample Nos. 18 and 19 (introduced mixed gas: Ar + CF₄, RF-discharge samples), since absorption was large, the refractive index and the extinction coefficient could not be measured. Furthermore, Fig. 3 shows transmittance and reflectance curves of the samples prepared using an introduced mixed gas of Ar + CF₄. As compared with the transmittance and reflectance curves of the samples prepared using an introduced mixed gas of Ar + O₂, which is shown in Fig. 2, it was found that, in the AC discharge ((a) of Fig. 3), films that absorbed light at the short-wavelength side were obtained. In addition, in the RF discharge ((b) of Fig. 3), films that further absorbed light were obtained. Note that, in Table 2, the refractive indices of the samples prepared using an introduced mixed gas of Ar + CO₂ (Sample Nos. 15 and 16) were high; about 1.6.

According to the above results, it is believed that, in order to prepare a thin film that has a lower refractive index than that of SiO₂ and that does not have absorption in the visible light range using a MgF₂-SiO₂ (70:30 atomic percent) target, it is necessary to deposit in an Ar + O₂ atmosphere using AC discharge. It is believed that an appropriate O₂ flow rate ratio in this case is in the range of 10% to 70%.

### (EXAMPLE 2)

A description will be made of an example of a deposition of an antireflection film using the reactive sputtering apparatus SE shown in Fig. 1.

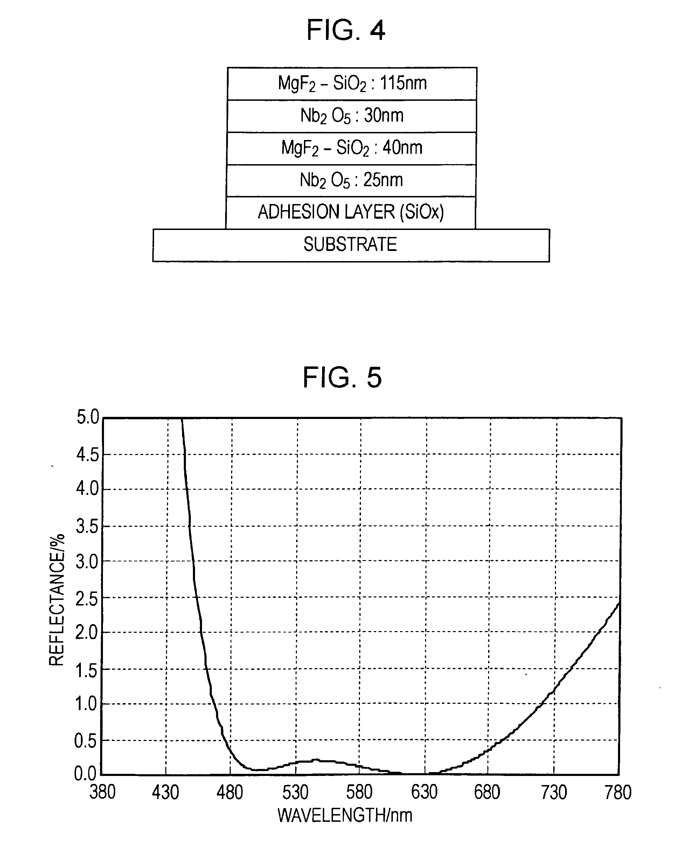

Here, an antireflection film having the structure shown in Fig. 4 was prepared in the order described below on the basis of the respective deposition conditions below.
(1) Substrate: Glass substrate
(2) Adhesion layer: SiOₓ
   · Sputtering target: B-doped polycrystalline Si
   · Sputtering gas: Ar
   · Reactive gas: O₂
(3) High-refractive-index layer a: Nb₂O₅
   · Sputtering target: Metal Nb
   · Sputtering gas: Ar
   · Reactive gas: CO₂
   · Film thickness: 25 nm
(4) Low-refractive-index layer a: MgF₂-SiO₂
   · Sputtering targets 4A and 4B: MgF₂-SiO₂ sintered body (MgF₂:SiO₂ = 70:30 atomic percent)
   · Sputtering gas: Ar
   · Reactive gas: O₂
   · Deposition conditions: The same as those used in Sample No. 4 in Example 1
   · Film thickness: 40 nm
(5) High-refractive-index layer b: Nb₂O₅
   · Sputtering target: Metal Nb
   · Sputtering gas: Ar
   · Reactive gas: CO₂
   · Film thickness: 30 nm
(6) Low-refractive-index layer b: MgF₂-SiO₂
   · Sputtering targets 4A and 4B: MgF₂-SiO₂ sintered body (MgF₂:SiO₂ = 70:30 atomic percent)
   · Sputtering gas: Ar
   · Reactive gas: O₂
   · Deposition conditions: The same as those used in Sample No. 4 in Example 1
   · Film thickness: 115 nm

Fig. 5 shows a measurement result of a spectral reflectance characteristic of the obtained antireflection film sample. In the measurement of the reflectance, a blackening treatment was performed on the reverse face of the sample in order to remove reflection components.

## Claims

1. A method of depositing a low-refractive-index film comprising depositing a low-refractive-index film composed of MgF₂-SiO₂ on a substrate by a reactive sputtering method,
**characterized in that** sputtering deposition is conducted using a target composed of a sintered body of MgF₂-SiO₂ by applying an alternating voltage with a frequency in the range of 20 to 90 kHz between the substrate and the target in an atmosphere of a mixed gas of an inert gas and O₂.

2. The method of depositing a low-refractive-index film according to Claim 1, **characterized in that** the content of SiO₂ in the target is in the range of 5 to 80 mole percent.

3. The method of depositing a low-refractive-index film according to Claim 1, **characterized in that** an O₂ flow rate ratio of the mixed gas is in the range of 10% to 70%.

4. A low-refractive-index film **characterized by** being deposited by the method of depositing a low-refractive-index film according to any one of Claims 1 to 3.

5. An antireflection film **characterized in that** a high-refractive-index layer and a low-refractive-index layer composed of the low-refractive-index film according to Claim 4 are stacked on a substrate.
